# EUROPEAN PATENT APPLICATION

(11) **EP 3 757 593 A1**
(43) Date of publication of application: **30.12.2020**
(21) Application number: 19182833.4
(22) Date of filing: 27.06.2019
(51) Int. Cl.: G01R 33/34

(54) **RF COIL ASSEMBLY AND MRI APPARATUS**

(71) Applicant: Koninklijke Philips N.V., 5656 AG Eindhoven (NL)
(72) Inventor: DENG, Wen (Wayne), 5656 AE Eindhoven (NL); WU, Bing, 5656 AE Eindhoven (NL); HARVEY, Paul Royston, 5656 AE Eindhoven (NL)
(74) Representative: de Haan, Poul Erik

(57) **Abstract**

The present invention provides a RF coil assembly comprising a first rigid frame and a flexible coil having a first end, a second end opposite to the first end and a longitudinal axis extending from the first end to the second end, the flexible coil configured to be attached to the first rigid frame at the first end, wherein the first rigid frame is shaped to bend a first portion of the flexible coil at a proximity of the first end along both a first bending axis and a second bending axis to form a first bending region in a substantially concave contour and to bend a second portion of the flexible coil along the first bending axis to form a second bending region in a substantially half tubular contour when the flexible coil is attached to the first rigid frame, the first bending axis is parallel to the longitudinal axis and the second bending axis is perpendicular to the longitudinal axis and at a proximity of the first end. According to the present invention, the RF coil assembly is not only lighter and better match to the regions of different subjects to be imaged but also may be used as a multiple purpose coil assembly to be applicable to different "curved" regions of the subject to be imagined.

## Description

### FIELD OF THE INVENTION

The invention relates to a RF (radio frequency) coil assembly. More particularly, the present invention relates to a RF coil assembly adapted to be used with a magnetic resonance imaging (MRI) apparatus. The present invention also relates to a MRI apparatus comprising the RF coil assembly.

RF coil assemblies are used in a MRI apparatus. In addition to "flat" coil assemblies which are lightweight and would be used for MRI scans on a region of a subject such as the abdomen, there are "curved" coil assemblies, which take a non-planar form. The "curved" coil assemblies have typically hard plastics housing for enclosing a flexible coil to hold the coil assembly in the desired configuration. The "curved" coil assemblies would be used for MRI scans on the region of the subject such as the head, the shoulder or the ankle where a substantially flat coil assembly is not appropriate. This kind of "curved" coil assemblies is usually cumbersome and fairly heavy. If the size and shape of a "curved" coil assembly required for a particular subject is not available, it can be time consuming to replace a "curved" coil assembly for that subject. In addition, different "curved" coil assemblies are usually required for different "curved" regions of a subject such as the head, the shoulder or the ankle, which not only increases the cost but also results in difficulty in storage and management of the "curved" coil assemblies.

Thus, there is a need to make improvements on the known non-planar "curved" coil assemblies.

### SUMMARY OF THE INVENTION

The present invention seeks to provide non-planar "curved" coil assemblies that are not only lighter and better match to the regions of different subjects to be imaged than prior such coil assemblies but also applicable to different "curved" regions of the subject to be imagined.

According to one aspect of the present invention, it is to provide a RF coil assembly comprising:
- a first rigid frame; and
- a flexible coil having a first end, a second end opposite to the first end and a longitudinal axis extending from the first end to the second end, the flexible coil configured to be attached to the first rigid frame at the first end;
wherein the first rigid frame is shaped to bend a first portion of the flexible coil at a proximity of the first end along both a first bending axis and a second bending axis to form a first bending region in a substantially concave contour and to bend a second portion of the flexible coil along the first bending axis to form a second bending region in a substantially half tubular contour when the flexible coil is attached to the first rigid frame, the first bending axis is parallel to the longitudinal axis and the second bending axis is perpendicular to the longitudinal axis and at a proximity of the first end. According to the present invention, the RF coil assembly is not only lighter and better match to the regions of different subjects but also maybe used as a multiple purpose coil assembly to be applicable to different "curved" regions of the subjects.

According to one embodiment of the present invention, the concave contour of the RF coil assembly conforms to a convex contour of a region of a subject and the half tubular contour of the RF coil assembly conforms to a half tubular contour of the region of the subject. According to another embodiment of the present invention, the RF coil assembly is operable for scanning multiple regions of a subject including head, shoulder and ankle. Advantageously, the concave contour portion and the half tubular contour portion of the flexible coil formed as a result of attaching the flexible coil to the first rigid frame can conform to multiple regions of a subject, thereby providing a multiple purpose RF coil assembly. The resulting shape of the RF coil assembly is conceived from the inventor's observation that the scan regions like the head, the shoulder and the ankle exhibit similar patterns of contours, which include a convex contour and a half tubular contour. To conform to the scan regions with such contour patterns, the RF coil assembly with the concave contour portion and the half tubular contour portion is designed. Moreover, the rigid frame allows the positioning of the RF coil assembly easier and faster as compared to the conventional flexible coils.

According to another embodiment of the present invention, the first rigid frame is shaped to slope from a top of a head towards a forehead. In this way, the first rigid frame can match the head of the subject to improve the subject's comfort.

According to another embodiment of the present invention, the first rigid frame is shaped into a substantially hemispherical cap or a substantially half bowl. Of course, the substantially hemispherical cap is unnecessarily in a standard hemispherical shape and is even a portion of the hemispherical shape. In this ways, the first rigid frame is easily shaped and the RF coil assembly has the desired configuration once the flexible coil is attached to the first rigid frame.

According to another embodiment of the present invention, the first end is curved as a result of the bending along the first bending axis and the second bending axis, the second end is curved as a result of the bending along the first bending axis, a portion of the sides of the flexible coil at a proximity of the first end is curved as a result of the bending along the second bending axis, wherein a curve bending line is formed in the flexible coil as a result of the bending along the second bending axis, the first bending region is bounded by the curved first end, the curved portion of the sides and the curve bending line and the second bending region is bound by the curve bending line, the straight portion of the sides and the curved second end.

According to another embodiment of the present invention, the first rigid frame comprises a first part and a second part that are buckled together, the flexible coil comprises a flexible printed circuit board, the flexible printed circuit board is partially covered with foam while a first exposed portion of the flexible printed circuit board at the first end exposes out of the foam, the first exposed portion of the flexible printed circuit board is retained between the first part and the second part. As a result, the RF coil assembly can be assembled easily.

According to another embodiment of the present invention, the first part has a convex surface on a side facing the second part, a plurality of positioning studs project from the convex surface, a plurality of positioning holes are formed in the first exposed portion of the flexible printed circuit board, the positioning studs pass through the respective positioning holes in the first exposed portion of the flexible printed circuit board, the contour of the convex surface and the distribution of the positioning studs on the convex surface and the positioning holes in the first exposed portion are configured in such a way that the flexible coil has the concave contour in a proximity of the first end and the half tubular contour in the remaining portion of the flexible coil. As a result, it is unnecessary to perform any complicated operation during assembly of the RF coil assembly.

According to another embodiment of the present invention, the RF coil assembly further comprises a second rigid frame disposed at the second end of the flexible coil. The second rigid frame helps to maintain the shape of the RF coil assembly and is convenient for an operator to hold the RF coil assembly.

According to another embodiment of the present invention, the RF coil assembly further comprises a control board and a pre-amplifier housed between the first part and the second part. The control board and the pre-amplifier housed within the rigid frame are not damaged easily.

According to another embodiment of the present invention, the RF coil assembly further comprises a hinge mechanism disposed at the second part of the first rigid frame to hinge detachably the first rigid frame to a support. The hinge mechanism allows the RF coil assembly to pivot relative to the support to receive the region of the subject.

According to another embodiment of the present invention, the hinge mechanism comprises a pair of movable blocks each having a pivot shaft, a spring for acting on the movable blocks to move the movable blocks away from each other, and an operating plate for abutting against the movable blocks to move the movable blocks toward each other to retract the pivot shafts. In this way, the RF coil assembly may be detached easily from the support.

According to another embodiment of the present invention, the RF coil assembly can be hinged detachably to a base coil assembly to form together a head coil assembly, the base coil assembly comprises a pair of support ribs for supporting the flexible coil of the RF coil assembly when the RF coil assembly is in a closed position. In this way, the RF coil assembly can be used a top coil assembly of a head coil assembly.

According to another embodiment of the present invention, the second end has flexibility so that the sides of the flexible coil at the second end can be compressed toward each other to pivot the flexible coil into a space between the pair of support ribs. In this way, the flexible coil may better match the subject's head of a small size, thereby obtaining a high quality image.

According to other aspect of the present invention, it is to provide a MRI apparatus comprising the RF coil assembly.

These and other objects, features and characteristics of the present invention, as well as the methods of operation and functions of the related elements of structure and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the invention.

### BRIEF DESCRIPTION OF THE DRAWINGS

Fig. 1 is a perspective view showing a RF coil assembly according to a preferred embodiment of the present invention.
Fig. 2 is other perspective view of the RF coil assembly as shown in Fig. 1.
Fig. 3 is a perspective view showing a first part of a first rigid frame of the RF coil assembly as shown in Fig. 1.
Fig. 4 is other perspective view of the first part of the first rigid frame as shown in Fig. 3.
Fig. 5 is a perspective view showing a second part of a first rigid frame of the RF coil assembly as shown in Fig. 1.
Fig. 6 is other perspective view of the second part of the first rigid frame as shown in Fig. 5.
Fig. 7 is a perspective view showing a flexible coil of the RF coil assembly as shown in Fig. 1.
Fig. 8 is a partial perspective view showing the flexible coil attached to the first part of the first rigid frame.
Fig. 9 is a perspective view similar to FIG. 8 with a positioning pad disposed on the flexible coil.
Fig. 10 is an exploded perspective view showing a hinge mechanism of the RF coil assembly as shown in Fig. 1.
Fig. 11 is a partial cross section showing the hinge mechanism as shown in Fig. 10.
Fig. 12 is a perspective view showing the hinge mechanism as shown in Fig. 10 in a first position.
Fig. 13 is a perspective view showing the hinge mechanism as shown in Fig. 10 in a second position.
Fig. 14 is a perspective view showing the RF coil assembly as shown in Fig. 1 and a base coil assembly on which the RF coil assembly can be mounted.
Fig. 15 is a perspective view showing the RF coil assembly as shown in Fig. 1 mounted on the base coil assembly being in a closed position.
Fig. 16 is other perspective view showing the RF coil assembly as shown in Fig. 1 mounted on the base coil assembly being in a closed position.
Fig. 17 is a side view showing the RF coil assembly as shown in Fig. 1 mounted on the base coil assembly being in an opened position.
Fig. 18 is a top view showing the RF coil assembly as shown in Fig. 1 used as a part of a head coil assembly.
Figs. 19 and 20 are perspective views showing the RF coil assembly well matching to a head of different subjects while being used as a part of a head coil assembly.
Fig. 21 is a top view showing the RF coil assembly as shown in Fig. 1 used as a shoulder coil assembly.

### DETAILED DESCRIPTION OF THE EXEMPLARY EMBODIMENTS

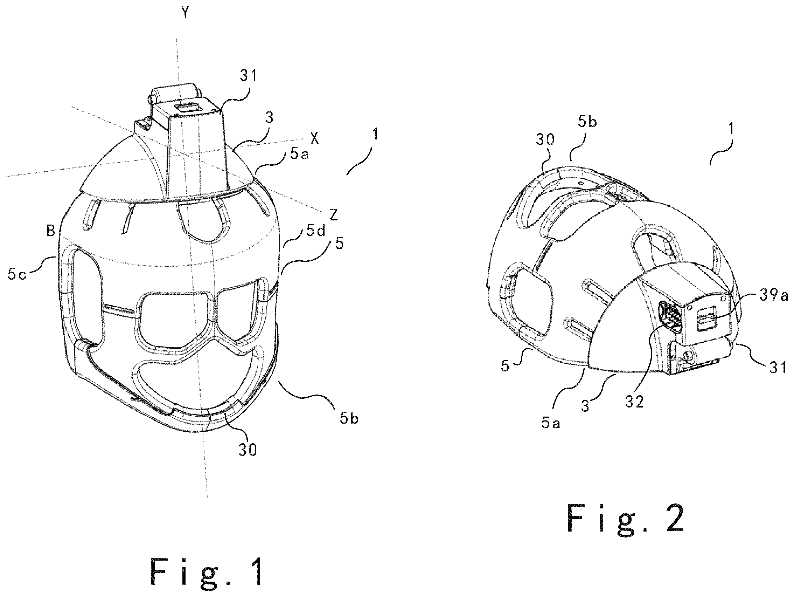

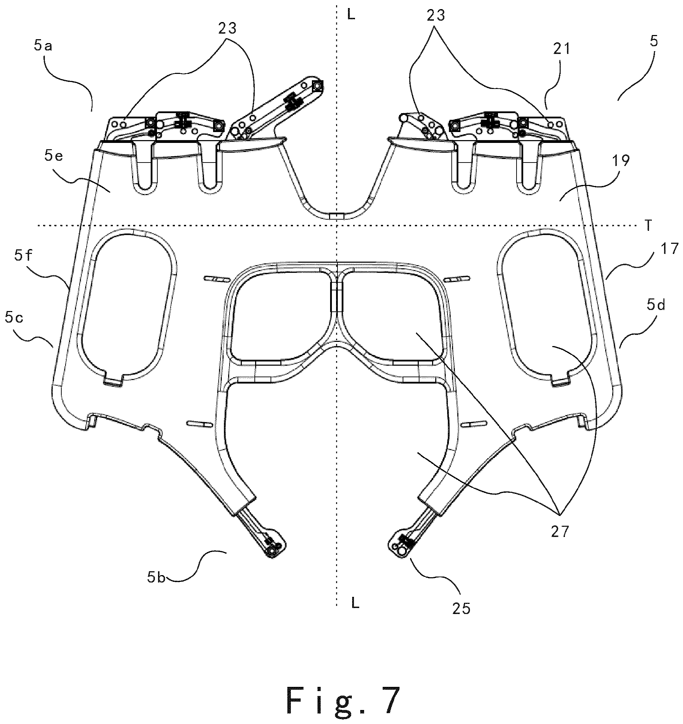

Fig. 1 is a perspective view showing a RF coil assembly according to a preferred embodiment of the present invention. Fig. 2 is other perspective view of the RF coil assembly as shown in Fig. 1. As shown in Figs 1 and 2, a RF coil assembly 1 according to the present invention comprises a first rigid frame 3 and a flexible coil 5 attached to the first rigid frame 3. Fig. 7 is a perspective view showing a flexible coil of the RF coil assembly as shown in Fig. 1. The flexible coil 5 has a first end 5a, a second end 5b opposite to the first end 5a and two opposite sides 5c, 5d between the first end 5a and the second end 5b. The flexible coil 5 has a longitudinal axis L extending substantially from the first end 5a to the second end 5b and a traverse axis T perpendicular to the longitudinal axis L. The flexible coil 5 substantially extends in a plane defined by the longitudinal axis L and the traverse axis T and thus is initially in a planar shape before the flexible coil 5 is attached to the first rigid frame 3. The flexible coil 5 has an inner surface 5e configured to be placed over a region of subject and an external surface 5f opposite to the inner surface 5e. The first rigid frame 3 is shaped to bend the flexible coil 5 along a first bending axis Y parallel to the longitudinal axis L and further bend the flexible coil 5 along a second bending axis X perpendicular to the longitudinal axis L (or parallel to the traverse axis T) when the flexible coil 5 is attached to the first rigid frame 3 at the first end 5a. The bending along the first bending axis Y forms approximately a 180 degree bend which shapes the initially planar flexible coil 5 into a substantially half tubular shape. A bend angle of the bending along the second bending axis X is determined to conform to any of the bend angle of the curve running from the top of the head to the forehead, the bend angle of the curve of the shoulder point and the bend angle of the curve of the heel. Since the bend angles of these curves have a close resemblance, the bend angle as determined above can conform to any of these curves. In addition, as the flexible coil 5 is attached to the first rigid frame 3 at the first end 5a, the second bending axis X is at a proximity of the first end 5a and only the region of the flexible coil 5 at a proximity of the first end 5a experiences the bending along the second bending axis X. As a result of the bending along the second axis X, the first end 5a is pushed inward and towards the second end 5b of the flexible coil 5 to further bend a portion of the flexible coil 5 at the first end 5a so that the shape of a substantially semicircle is formed at a proximity of the first end 5a and a bending line B is formed in the flexible coil 5.

As such, a first bending region bounded by the curved first end 5 a, the curved portion of the sides 5c, 5d of the flexible coil 5 and the bending line B is formed into a substantially concave contour as a result of the bendings along the first and second bending axes X and Y. The concave contour conforms to the curve running from the top of the head to the forehead, the shoulder point and the heel. A second bending region bounded by the bending line B, the straight portion of the sides of the flexible coil 5 and the curved second end 5b is formed into a substantially half tubular contour as a result of the bending along the first bending axis Y. The half tubular contour conforms to the curve of the face, the upper arm and lower leg. The longitudinal length and the traverse width of the flexible coil 5 are sized such that the regions of the subject can be received in the first bending region and the second bending region. Advantageously, the flexible coil 5 is bent into a curvature with multiple curve patterns, e.g., the concave pattern and the half tubular pattern to conform to the complicated curvature of the region of the subject. Moreover, the concave pattern and half tubular pattern combination conform to multiple regions of the subject, e.g., the head, the shoulder and the ankle. Therefore, the RF coil assembly shaped into the specific curvature can be used as a multiple purpose coil.

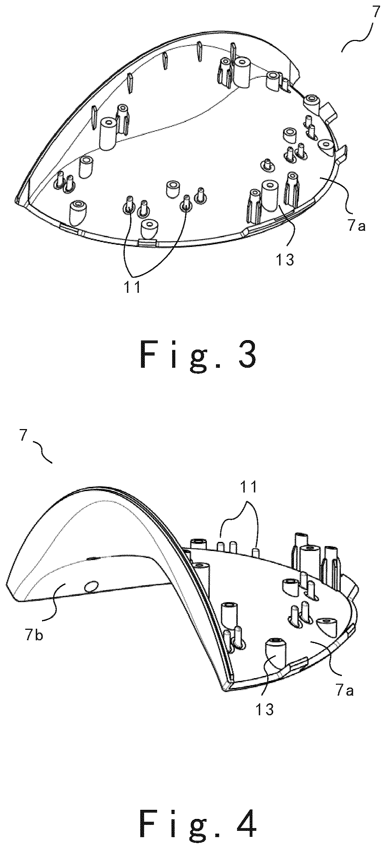

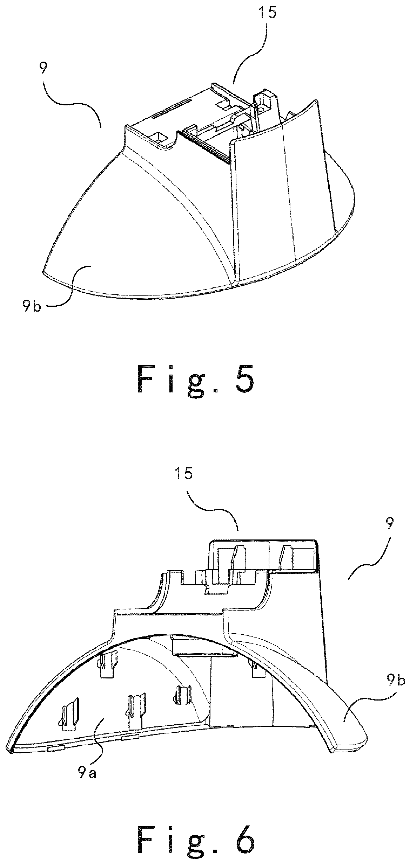

Fig. 3 is a perspective view showing a first part of a first rigid frame of the RF coil assembly as shown in Fig. 1. Fig. 4 is another perspective view of the first part of the first rigid frame as shown in Fig. 3. Fig. 5 is a perspective view showing a second part of a first rigid frame of the RF coil assembly as shown in Fig. 1. Fig. 6 is another perspective view of the second part of the first rigid frame as shown in Fig. 5. As shown in Figs. 3-6, in one embodiment, the first rigid frame 3 comprises a first part 7 and a second part 9 that are separately injection moulded. The first part 7 and the second part 9 can be buckled together to form the first rigid frame 3. The first part 7 has a concave surface 7a configured to be placed over the region of the subject and a convex surface 7b opposite to the concave surface 7a. A plurality of positioning studs 11 and a plurality of threaded studs 13 project from the convex surface 7b. The second part 9 has a concave surface 9a which corresponds with the convex surface 7b of the first part 7 and a hinge mechanism seat 15 on a convex surface 9b opposite to the concave surface 9a.

As the concave surface 7a is configured to be placed over the region of the subject, e.g., the top of the head, it can be shaped to slope from the top of the head down towards the forehead. As the curve of the top of the head has a close resemblance to the curve of the shoulder and posterior end of the foot, the concave surface 7a as shaped above is readily applicable to the other regions, e.g., the shoulder and the posterior end of the foot. The flexible coil 5 is attached to the corresponding convex surface 7b to form the first bending region which extends smoothly from the convex surface 7b and slope down to the bending line B. As such, the concave surface of the first rigid frame 3 and the inner concave surface of the first bending region of the flexible coil 5, which are placed over the region of the subject, can better conform to the convex pattern, e.g., the curve from the top of the head down to the forehead. The inner half tubular surface of the second bending region conforms to the half tubular pattern of the face. Advantageously, the overall RF coil assembly results in the concave contour and half tubular contour which conform to the region of the subject comprised of multiple contour patterns, e.g., the convex contour and half tubular contour of the head, shoulder or the ankle.

Alternatively, the first rigid frame 3 is shaped into half of a spherical cap to be placed over the upper top of the head. When the flexible coil 5 is attached to the convex surface 7b in the hemispherical cap shape, the flexible coil 5 is shaped into the concave bending region and the half tubular bending region. The overall RF coil assembly thereby better conform to the region of the subject which comprises the convex pattern and half tubular pattern. Similarly, the concave surface 7a can also be shaped into a half bowl shape for the purpose of producing the overall RF coil assembly which better conforms to the region of the subject comprised of multiple contour patterns. It is contemplated by the skilled in the art that the shape described herein, e.g., the semicircular, the concave, the half tubular, the convex, the hemispherical cap, the half bowl, etc., is not precise but includes the shape with a close resemblance to the described shape.

Advantageously, the overall RF coil assembly can conform to multiple regions which have similar but complex contour patterns, e.g., the convex pattern and the half tubular pattern of the head, shoulder and ankle. Moreover, the first rigid frame 3 makes the positioning and fastening of the RF coil assembly easier and faster as compared to the conventional flexible coil. When used as the head top coil, the RF coil assembly can replace the conventional rigid head top coil to be attached directly to the conventional head base, which archives upgrade of the conventional rigid head coil to the head coil of the present invention with minimum cost and effort. Furthermore, the second end 5b distal to the first rigid frame 3 is still kept flexible, which can be deformed to better conform to subjects of various sizes or the different regions of the subject.

Fig. 7 is a perspective view showing a flexible coil of the RF coil assembly as shown in Fig. 1. As shown in Fig 7, the flexible coil 5 is flat before attached to the first rigid frame 3. The flexible coil 5 comprises a flexible printed circuit board 17. The flexible printed circuit board 17 is partially covered with biocompatible foam 19 while a first exposed portion 21 of the flexible printed circuit board 17 exposes out of the foam 19 at the first end 5a of the flexible coil 5. The foam 19 can be applied by a thermoforming method using moulds or by a layered method using foam and adhesives. There are a plurality of positioning holes 23 in the first exposed portion 21 of the flexible printed circuit board 17. In one embodiment, there is a second exposed portion 25 at a second end 5b of the flexible coil 5 opposite to the first end 5a. A few openings 27 are formed in the flexible coil 5 to allow the subject's eyes, ears, noses and mouth not to be covered by the flexible coil 5 while the RF coil assembly is used as a top of a head coil assembly, thereby improving the subject's comfort.

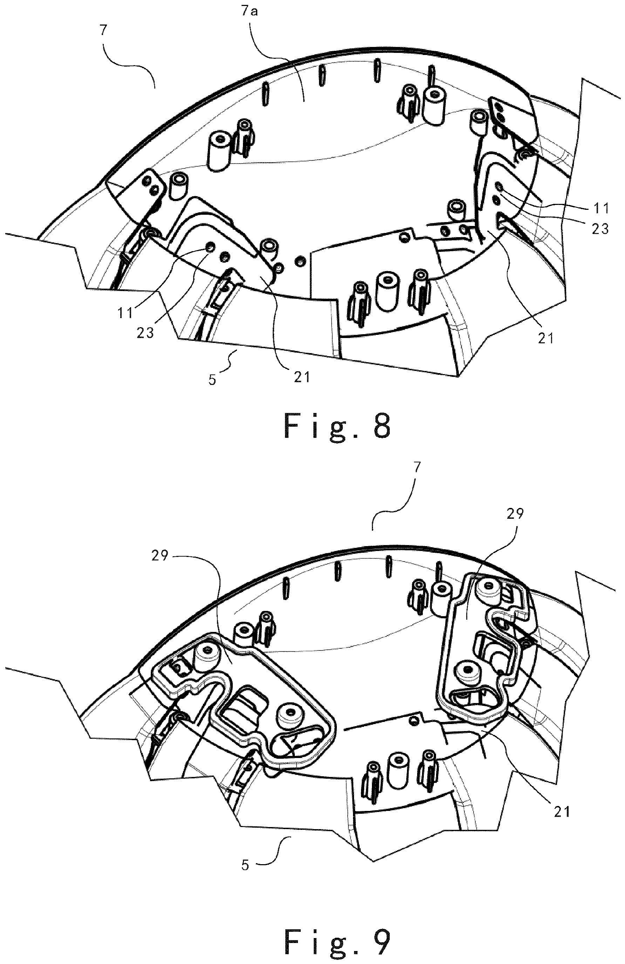

Fig. 8 is a partial perspective view showing the flexible coil attached to the first part of the first rigid frame. Fig. 9 is a perspective view similar to Fig. 8 with a positioning pad disposed on the flexible coil. When the RF coil assembly is assembled, as shown in Fig 8, the flexible coil 5 is first attached to the first part 7 of the first rigid frame 3 with the positioning studs 11 on the convex surface 7b of the first part 7 passing through the respective positioning holes 23 in the first exposed portion 21 of the flexible printed circuit board 17. The contour of the convex surface 7b and the distribution of the positioning studs 11 on the convex surface 7a of the first part 7 and the positioning holes 23 in the first exposed portion 21 are configured in such a way that the flexible coil 5 is bent into the concave contour in a proximity of the first end 5a and the half tubular contour in the remaining portion of the flexible coil after the flexible coil 5 is attached to the first part 7 of the first rigid frame 3. By means of the positioning studs 11 on the convex surface 7b of the first part 7 and the positioning holes 23 in the first exposed portion 21, it is very easy to attach the flexible coil 5 to the first part 7 and render the flexible coil 5 to have the desired contour.

A positioning pad 29 maybe disposed on the first exposed portion 21 of the flexible printed circuit board 17 attached to the first part 7 to prevent the first exposed portion 21 from shifting relative to the first part 7. After other possible electronic devices such as a control board and a pre-amplifier of the RF coil assembly are connected with the first exposed portion 21, the second part 9 is buckled onto the first part 7. Then, the first part 7 and the second part 9 are fastened together by screws passing through the second part 9 and threaded into the threaded studs 13 on the first part 7 so that the first exposed portion 21 of the flexible printed circuit board 17 and the other possible electronic devices of the RF coil assembly are securely retained between the first part 7 and the second part 9 to form the RF coil assembly 1. The control board and the pre-amplifier are housed within the rigid frame 3 so that they are not damaged easily. Preferably, the RF coil assembly 1 may comprise a second rigid frame 30 at the second end 5b of the flexible coil 5 to securely retain the second exposed portion 25. The second rigid frame 30 may be in a handle shape so that it helps to maintain the shape of the RF coil assembly 1 and is convenient for an operator to hold the RF coil assembly 1. Of course, it is feasible that the second rigid frame 30 is disposed at the foam covered portion of the flexible coil 5 without the second exposed portion at the second end 5b.

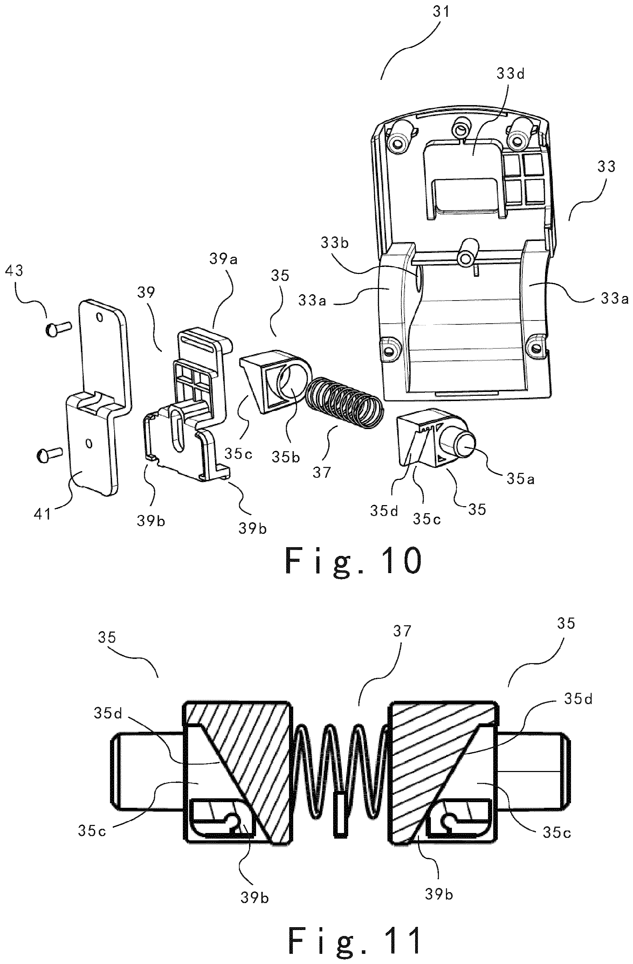

The RF coil assembly 1 according to the present invention may further comprise a retractable hinge mechanism 31 mounted onto the hinge mechanism seat 15 of the second part 9 and an interface 32 provided at the second part 9 of the first rigid frame 3 in electrical communication with the flexible coil 5. Fig. 10 is an exploded perspective view showing a hinge mechanism of the RF coil assembly as shown in Fig. 1. As shown in Fig. 10, the retractable hinge mechanism 31 comprises a bracket 33 and a pair of movable blocks 35. The bracket 33 has a pair of side plates 33a facing to each other. Each of the movable blocks 35 has a pivot shaft 35a projecting from a side of the main body of the movable block and a blind hole 35 b formed in the main body opposite to the pivot shaft 35a. The movable blocks 35 each have a skewed slot 35c having a bevel 35d. The movable blocks 35 are disposed between the pair of side plates 33a of the bracket 33 with the pivot shaft 35a extending through a through hole 33b in the side plates 33a respectively. Two ends of a spring 37 are received within the blind hole 35b of the movable blocks 35 respectively so that the movable blocks 35 always move away from each other. The hinge mechanism 31 further comprises an operating plate 39 having an operating button 39a formed at one end and two projections 39b at other end. FIG. 11 is a partial cross section showing the hinge mechanism as shown in FIG. 10. After the operating plate 39 is mounted in place by a fixing plate 41 which is fastened onto the bracket 33 by screws 43, the operating button 39a of the operating plate 39 extends through an opening 33d in the bracket 33 to be accessible from outside and two projections 39b extend into the skewed slot 35c of the respective movable blocks 35 to abut against the bevel 35d, as shown in Fig. 11.

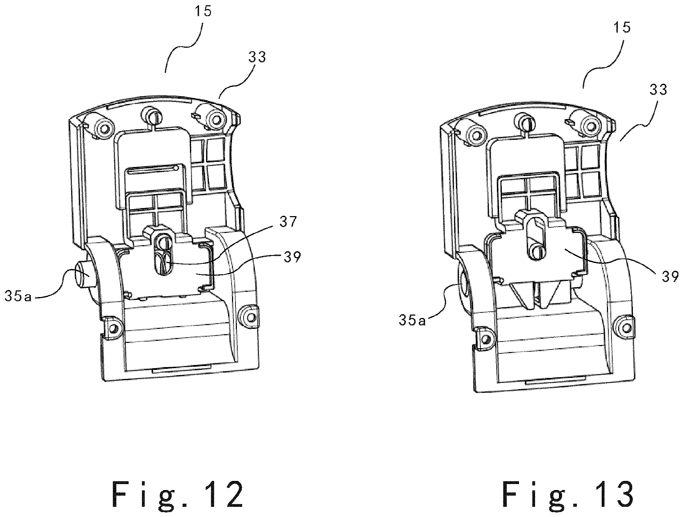

Fig. 12 is a perspective view showing the hinge mechanism as shown in Fig. 10 in a first position. Fig. 13 is a perspective view showing the hinge mechanism as shown in Fig. 10 in a second position. In an usual state, the pivot shaft 35a of each movable block 35 extends out of the through hole 33b in the side plates 33a under an action of the spring 37, as shown in Fig. 12. When the operating button 39a of the operating plate 39 is pulled upward relative to the bracket 33, the two projections 39b abut against the bevel 35d of the respective movable blocks 35 and move the movable blocks 35 toward each other so that the pivot shaft 35a of each movable block 35 retracts relative to the bracket 33, as shown in Fig. 13. When the operating button 39a of the operating plate 39 is released, the spring 37 pushes the pivot shafts 35a of the movable blocks 35 to extend out of the through hole 33b in the side plates 33a again, as shown in Fig. 12. It should be understood that the hinge mechanism 31 can be implemented in other ways. For example, the movable blocks 35 and the operating plate 39 may be configured in such a way that the pivot shaft 35a of each movable block 35 retracts relative to the bracket 33 when the operating plate 39 moves downward relative to the bracket 33. Further, the bracket 33 may be omitted and a portion of the first rigid frame 3 may function as the bracket 33.

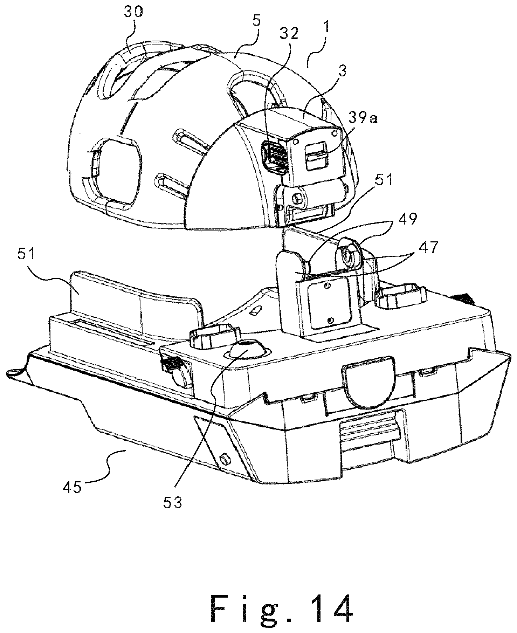

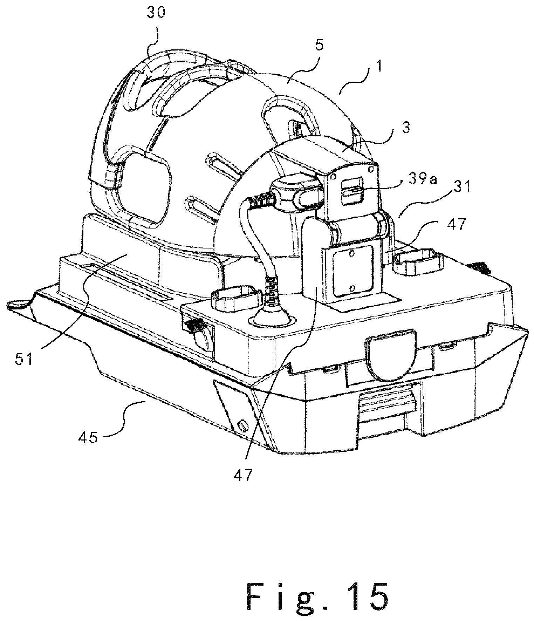

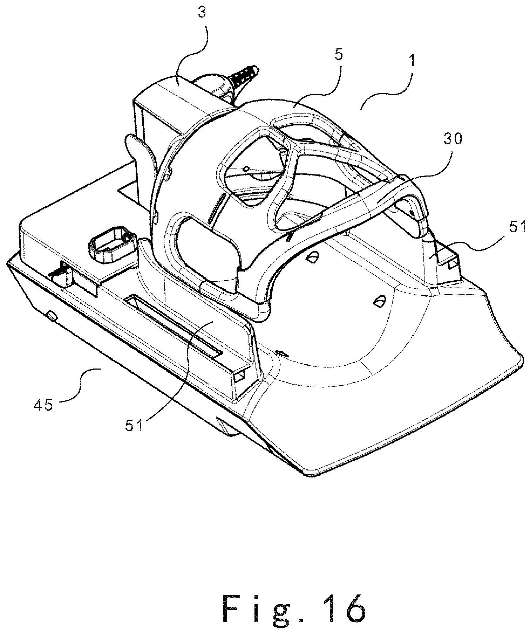

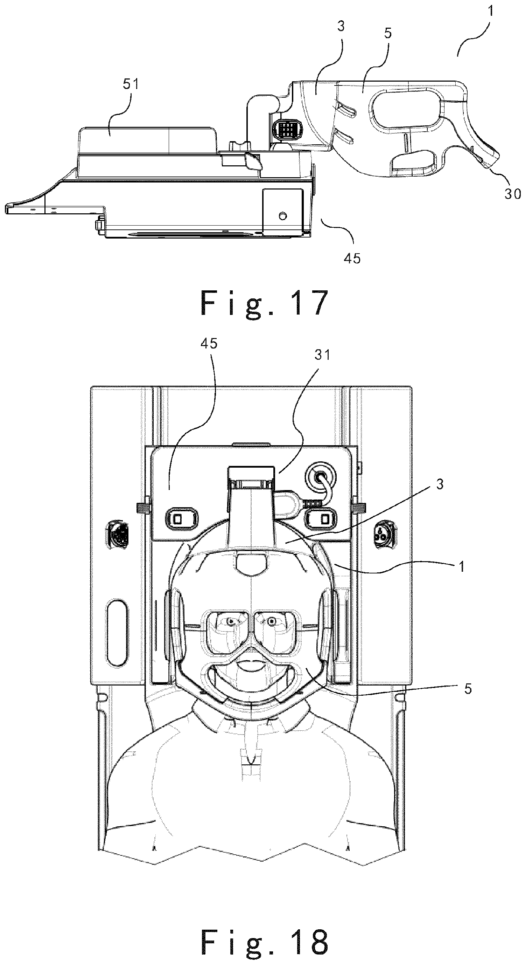

Fig. 14 is a perspective view showing the RF coil assembly as shown in Fig. 1 and a base coil assembly on which the RF coil assembly can be mounted. The base coil assembly 45 is configured to support the subject's head when the subject's head is imagined and comprises a coil disposed within a rigid housing. There are a pair of support arms 47 on the base coil assembly 45. A hole 49 for receiving the pivot shaft 35a of the movable block 35 is formed in each of the support arms 47 so that the RF coil assembly 1 may be mounted detachably onto the base coil assembly 45. Specifically, when it is necessary to mount the RF coil assembly 1 onto the base coil assembly 45, the operating button 39a of the operating plate 39 is pulled upward so that the pivot shaft 35a of each movable block 35 retracts. While the pivot shaft 35a of each movable block 35 is in alignment with the hole 49 in the support arms 47, the operating button 39a of the operating plate 39 is released and the pivot shaft 35a extends into the respective hole 49. As a result, the RF coil assembly 1 is mounted pivotally onto the base coil assembly 45 to form together a head coil assembly. When the operating button 39a of the operating plate 39 is pulled upward again, the RF coil assembly 1 is detachable from the base coil assembly 45. There are a pair of support ribs 51 on the base coil assembly 45. The support ribs 51 support the flexible coil 5 of the RF coil assembly 1 when the RF coil assembly 1 is in a closed position, as shown in Figs. 15 and 16. There is an interface 53 in electrical communication with an Analog to Digital Converter of a MRI apparatus. Fig. 15 is a perspective view showing the RF coil assembly as shown in Fig. 1 mounted on the base coil assembly 45 being in a closed position. Fig. 16 is other perspective view showing the RF coil assembly as shown in Fig. 1 mounted on the base coil assembly 45 being in a closed position. Fig. 17 is a side view showing the RF coil assembly as shown in Fig. 1 mounted on the base coil assembly 45 being in an opened position. By grasping the second rigid frame 30, it is very easy for the operator to pivot the RF coil assembly from the closed position to the opened position or from the opened position to the closed position. Fig. 18 is a top view showing the RF coil assembly 1 used as a part of a head top coil assembly to scan the subject's head. It should be understood that the RF coil assembly 1 can be detachably attached to other support such as a subject support couch.

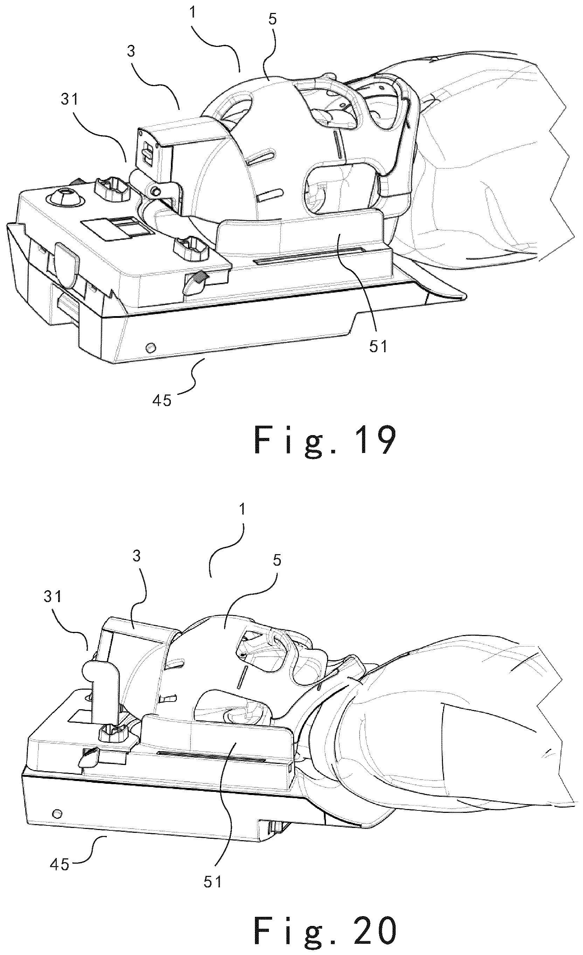

Figs. 19 and 20 are perspective views showing the RF coil assembly matching to a head of different subjects while being used as a part of a head top coil assembly. Generally, in the closed position, the flexible coil 5 of the RF coil assembly 1 is supported on the support ribs 51 on the base coil assembly 45 to match the shape and size of a majority of subjects. However, as shown in Fig. 19, since the second end 5b always has flexibility, by compressing the sides 5c, 5d of the flexible coil 5 at the second end 5b toward each other and pivoting the flexible coil 5 down into a space between the support ribs 51, the flexible coil 5 may better match the subject's head of a small size, thereby obtaining a high quality image. Compared with Fig. 19, the flexible coil 5 as shown in Fig. 20 is pivoted down much more to match a child's head.

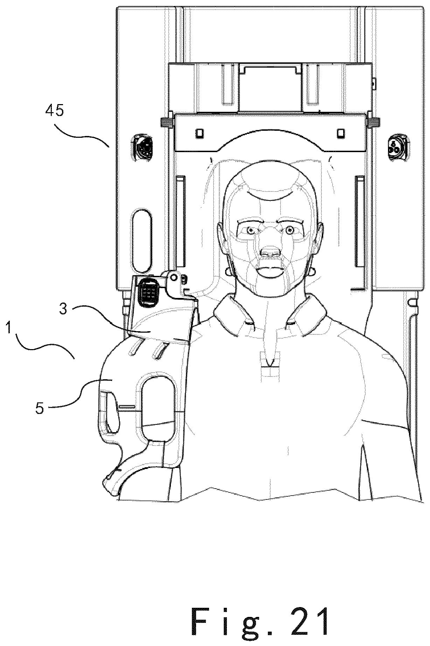

Fig. 21 is a top view showing the RF coil assembly as shown in FIG. 1 used as a shoulder coil assembly. As shown in Fig. 21, the RF coil assembly 1 is detached from the base coil assembly 45 and used as a shoulder coil assembly. The RF coil assembly 1 according to the present invention also matches well to a subject's shoulder. Of course, the RF coil assembly 1 also matches well to a subject's ankle and thus may be used as an ankle coil assembly.

Although the invention has been described in detail for the purpose of illustration, it is to be understood that such detail is solely for that purpose and that the invention is not limited to the disclosed embodiments, but on the contrary, is intended to cover modifications and equivalent arrangements that are within the spirit and scope of the appended claims.

## Claims

1. A RF coil assembly (1) comprising:
- a first rigid frame (3); and
- a flexible coil (5) having a first end (5a), a second end (5b) opposite to the first end (5a) and a longitudinal axis (L) extending from the first end (5a) to the second end (5b), the flexible coil (5) configured to be attached to the first rigid frame (3) at the first end (5a);
wherein the first rigid frame (3) is shaped to bend a first portion of the flexible coil (5) at a proximity of the first end (5a) along both a first bending axis (Y) and a second bending axis (X) to form a first bending region in a substantially concave contour and to bend a second portion of the flexible coil (5) along the first bending axis (Y) to form a second bending region in a substantially half tubular contour when the flexible coil (5) is attached to the first rigid frame (3), the first bending axis (Y) is parallel to the longitudinal axis (L) and the second bending axis (X) is perpendicular to the longitudinal axis (L) and at a proximity of the first end (5a).

2. The RF coil assembly (1) according to claim 1, wherein the concave contour of the RF coil assembly conforms to a convex contour of a region of a subject and the half tubular contour of the RF coil assembly conforms to a half tubular contour of the region of the subject.

3. The RF coil assembly (1) according to claim 1, wherein the RF coil assembly (1) is operable for scanning multiple regions of a subject including head, shoulder and ankle.

4. The RF coil assembly (1) according to claim 1, wherein the first rigid frame (3) is shaped to slope from a top of a head towards a forehead.

5. The RF coil assembly (1) according to claim 1, wherein the first rigid frame (3) is shaped into a substantially hemispherical cap or a substantially half bowl.

6. The RF coil assembly (1) according to claim 1, wherein the first end (5a) is curved as a result of the bending along the first bending axis (Y) and the second bending axis (X), the second end (5b) is curved as a result of the bending along the first bending axis (Y), a portion of the sides (5c, 5d) of the flexible coil (5) at a proximity of the first end (5a) is curved as a result of the bending along the second bending axis (X), wherein a curve bending line (B) is formed in the flexible coil (5) as a result of the bending along the second bending axis (X), the first bending region is bounded by the curved first end (5a), the curved portion of the sides (5c, 5d) and the curve bending line (B) and the second bending region is bound by the curve bending line (B), the straight portion of the sides (5c, 5d) and the curved second end (5b).

7. The RF coil assembly (1) according to claim 1, wherein the first rigid frame (3) comprises a first part (7) and a second part (9) that are buckled together, the flexible coil (5) comprises a flexible printed circuit board (17), the flexible printed circuit board (17) is partially covered with foam (19) while a first exposed portion (21) of the flexible printed circuit board (17) at the first end (5a) exposes out of the foam (19), the first exposed portion (21) of the flexible printed circuit board (17) is retained between the first part (7) and the second part (9).

8. The RF coil assembly (1) according to claim 7, wherein the first part (7) has a convex surface (7b) on a side facing the second part (9), a plurality of positioning studs (11) project from the convex surface (7b), a plurality of positioning holes (23) are formed in the first exposed portion (21) of the flexible printed circuit board (17), the positioning studs (11) pass through the respective positioning holes (23) in the first exposed portion (21) of the flexible printed circuit board (17), the contour of the convex surface (7b) and the distribution of the positioning studs (11) on the convex surface (7b) and the positioning holes (23) in the first exposed portion (21) are configured in such a way that the flexible coil (5) has the concave contour in a proximity of the first end (5a) and the half tubular contour in the remaining portion of the flexible coil.

9. The RF coil assembly (1) according to claim 1, further comprising a second rigid frame (30) disposed at the second end (5b) of the flexible coil (5).

10. The RF coil assembly (1) according to claim 7, further comprising a control board and a pre-amplifier housed between the first part (7) and the second part (9).

11. The RF coil assembly (1) according to claim 7, further comprising a hinge mechanism (31) disposed at the second part (9) of the first rigid frame (3) to hinge detachably the first rigid frame (3) to a support.

12. The RF coil assembly (1) according to claim 11, wherein the hinge mechanism (31) comprises a pair of movable blocks (35) each having a pivot shaft (35a), a spring (37) for acting on the movable blocks (35) to move the movable blocks (35) away from each other, and an operating plate (39) for abutting against the movable blocks (35) to move the movable blocks (35) toward each other to retract the pivot shafts (35a).

13. The RF coil assembly (1) according to claim 11, wherein the RF coil assembly (1) can be hinged detachably to a base coil assembly (45) to form together a head coil assembly, the base coil assembly (45) comprises a pair of support ribs (51) for supporting the flexible coil (5) of the RF coil assembly (1) when the RF coil assembly (1) is in a closed position.

14. The RF coil assembly (1) according to claim 13, wherein the second end (5b) has flexibility so that the sides (5c, 5d) of the flexible coil (5) at the second end (5b) can be compressed toward each other to pivot the flexible coil (5) into a space between the pair of support ribs (51).

15. A MRI apparatus comprising a RF coil assembly according to any one of claims 1-14.
